# EUROPÄISCHE PATENTSCHRIFT

(11) **EP 0 792 203 B1**
(45) Veröffentlichungstag und Bekanntmachung des Hinweises auf die Patenterteilung: **26.08.1998**
(21) Anmeldenummer: 95935360.8
(22) Anmeldetag: 21.10.1995
(51) Int. Cl.: B23Q 1/34, B25J 7/00

(54) **ELEKTROMECHANISCHE POSITIONIEREINHEIT**
ELECTROMECHANICAL POSITIONING UNIT
UNITE ELECTROMECANIQUE DE POSITIONNEMENT

(30) Priorität: 15.11.1994 DE 4440758
(43) Veröffentlichungstag der Anmeldung: 03.09.1997
(73) Patentinhaber: Klocke, Volker, 52070 Aachen (DE); KLEINDIEK, Stephan, D-72074 Tübingen (DE)
(72) Erfinder: KLEINDIEK, Stephan, D-72074 Tübingen (DE)
(74) Vertreter: von Creytz, Dietrich, Dipl.-Phys.
(86) Internationale Anmeldenummer: DE9501482
(87) Internationale Veröffentlichungsnummer: WO9614959

(56) Entgegenhaltungen:
- EP-A- 0 464 764
- WO-A-94/06160
- PATENT ABSTRACTS OF JAPAN vol. 14 no. 177 (M-960) ,9.April 1990 & JP,A,02 030452 (MITSUBISHI EL. CORP.)

## Beschreibung

Die Erfindung betrifft eine elektromechanische Positioniereinheit gemäß Oberbegriff des Anspruchs 1. Sie betrifft insbesondere eine Positioniereinheit als Trägheitsantrieb mit mindestens einem rohrförmigen, piezoelektrischen Aktuator mit beweglichem Läufer. Der Aktuator besitzt Elektroden zum Anschluß an variable Spannungen mit deren Hilfe der Läufer. Der Aktuator besitzt Elektroden zum Anschluß an variable Spannungen mit deren Hilfe der Läufer elektrisch kontrollierbar zu bewegen ist. Es soll sich der Läufer in diesem Piezo-Aktuator in Richtung der Piezobewegungen entlang einer rohrförmigen Reibungsoberfläche bewegen.

Positioniereinheiten dieser Art mit Nanometer-Präzision, die aktiviert durch Piezo-Aktuatoren auf dem Prinzip des Trägheitsantriebs beruhen, werden mit bis zu atomarer Auflösung als Positionierer, Analysegerät (z.B. Rastersondenmikroskop) und Werkzeug in der Mikro- und Nanotechnologie eingesetzt. Bei diesen Trägheitsantrieben wird die Verschiebung eines Läufers relativ zu der Reibungsoberfläche dadurch erreicht, daß bei starker Beschleunigung der Reibungsoberfläche die Trägheitskraft des Läufers größer wird als die Haftreibungskraft, so daß der Läufer der Bewegung der Reibungsoberfläche nicht mehr folgt.

Eine besonders kompakte Form der Positioniereinheit bilden die einachsigen Trägheitsantriebe, wie sie in DE 38 22 504 A1, in WO-A1-94/06160 und in Review Sci. Instr. 63 (1) (Jan. 1992, Seiten 263/264) beschrieben werden. Hiernach wird mit Hilfe eines oder mehrerer Piezo-Aktuatoren eine Reibungsoberfläche schnell und langsam bewegt. Diese Reibungsoberfläche umschließt einigermaßen gleichmäßig, insbesondere rohrförmig, den Läufer.

In DE 38 22 504 A1 wird ein Mikromanipulator mit mehreren Läufern, die das jeweilige Objekt zugleich stützen und bewegen sollen, beschrieben. Die Läufer mit den daran anschließenden, das Objekt unmittelbar aufnehmenden Auflageköpfen sollen piezoelektrisch in einer rohrförmigen Reibungsoberfläche verstellbar sein. Die Haftreibung dieser Läufer, die im Bekannten eine massive, zylinder-stempelartige Form besitzen und flexibel biegbare Elemente nicht aufweisen, läßt sich jedoch nicht justieren.

Eine Positioniereinheit gemäß Oberbegriff des Anspruchs 1 ist aus WO-A1-94/06160 bekannt. Der darin beschriebene Läufer ("low-mass support means") hat eine draht-ähnliche Form und ist über diese flexibel biegbare Form in der Stärke seiner Reibungshaftung in geringen Grenzen justierbar, das heißt nur in einem engen Verbiegungsbereich läßt sich eine sinnvolle Reibungshaftung einstellen. Diese Läuferform erlaubt nur dann eine Trägheitsantriebs- Bewegung, wenn die Reibungshaftung sehr klein ist. Daher lassen sich im Bekannten eine Meßspitze, z.B. die Spitze eines Rastertunnelmikroskops, nicht jedoch schwerere Objekte, bewegen. Auch können mit diesem Läufer nur extrem geringe Kräfte ausgeübt werden, da diese Kräfte limitiert werden durch die Stärke der Haftreibung.

Weiterhin sind die auf den Läufer nach WO-A1-94/06160 auszuübenden Kräfte auch beschränkt durch die Leistungsgrenze des Piezo-Aktuators. Der Übergang von der Haftung zum Gleiten hängt - neben den durch die verwendeten Oberflächen festgelegten unterschiedlichen Reibungskoeffizienten - wesentlich von der Stärke der über mindestens einen Piezo-Aktuator auf die Reibungs-Oberfläche übertragenen Pulsform und der Masse des Läufers ab. Da Piezo-Aktuatoren bei Anlegen von hohen Spannungen (ab ca. einigen 100 Volt) depolarisieren und dann keine Ausdehnungsbewegungen mehr vollziehen, ist der Einspeisung von Energie in den Trägheitsantrieb eine Obergrenze gesetzt.

In der Zeitschrift "Review Sci. Instr." 63 (1), Jan. 1992, Seiten 263/264, wird ein Läufer beschrieben, der aus den beiden Hälften eines längsgeteilten Zylinderstabs besteht, wobei die beiden Zylinderhälften in einem als Rohr ausgebildeten Piezo-Aktuator durch Reibungskräfte gehalten werden sollen. Zu diesem Zweck wird zwischen die beiden Zylinderhälften eine Feder eingesetzt, deren Federkraft gerade so groß ist, daß die den Läufer bildenden Zylinderteile nicht aus dem Rohr herausfallen und trotzdem durch Piezo-Kräfte in Längsrichtung des Rohrs zu bewegen sind. Im Bekannten ist es also außerordentlich schwierig, die Feder mechanisch so zu justieren, daß die Läuferhälften gerade durch Piezo-Kräfte in Längsrichtung des Rohrs zu bewegen sind. Der mechanische Aufbau des Läufers mit zwei Zylinderhälften und dazwischen liegenden diffizil zu justierenden mechanischen Federn ist so kompliziert, daß lichte Weiten für den Piezo-Aktuator von 19 bis 20 mm in der Praxis kaum zu unterschreiten sind. Durch die Größe der ganzen Vorrichtung wird diese gegenüber äußeren mechanischen Störungen, wie Trittschall, so empfindlich, daß ein Positionieren von Objekten bis zu atomarer Präzision normalerweise, das heißt z.B. ohne besondere Schwingungsdämpfersysteme, ausgeschlossen ist.

Ein praktischer Einsatz als Positioniereinheit setzt aber voraus, daß der Antrieb fehlertolerant gegen Variationen der Reibungshaftung ist, welche z.B. durch Alterung, Staub, Korrosion des Läufers, Änderung der Federkonstante, usw. auftritt. Diese Fehlertoleranz ist bei der Einheit nach der Zeitschrift Review Sci. Instr. 63 (1) nicht gegeben. In dieser Veröffentlichung konnte eine Bewegung des Läufers gegen die Schwerkraft nur erfolgen, wenn die "Piezoelectric ceramics" mit hohen Spannungen größer 50 Volt betrieben wurden. Ein Einsatz gegen größere Kräfte als die Schwerkraft ist damit ausgeschlossen; insbesondere kann die Einheit außer den Läufer selbst nichts heben.

Nach der vorgenannten Review Sci. Instrum. 63 (1) besteht die Läufer-Masse aus zwei Zylinderhälften, die mit Hilfe einer Feder gegen die Reibrohrwandung gedrückt werden. Wenn bei Betrieb die beiden Masseteile eine unterschiedliche Reibung gegenüber der Rohrwandung haben, was in der "Mikro"-Praxis kaum zu verhindern ist, laufen die beiden Masseteile asynchron. Sie können sich dadurch verkanten und im Reibrohr verklemmen. Ein wesentlicher Nachteil der bekannten Vorrichtung besteht also darin, daß der Läufer immer aus zwei Zylinderhälften und damit aus zwei Masseeinheiten, die quer zur Transportrichtung gegen die Innenwand des Reibrohrs gedrückt werden, bestehen muß.

Der Erfindung liegt die Aufgabe zugrunde, die Nachteile obiger Läuferformen zu beseitigen und dadurch einen einachsigen Trägheitsantrieb zu ermöglichen, der in seinem Vorschub pro Antriebspuls mit bequem einzuhaltender Toleranz justierbar ist, größere Lasten bewegen kann und hohe Kräfte auf Objekte ausüben bzw. übertragen kann sowie ohne Abschirmung gegenüber üblichen mechanischen Störungen, das heißt im normalen Labor, Zentimeter-(cm)-Bewegungen mit Nanometer-(nm)-Genauigkeit ausführen kann. Schließlich soll für den Positionierer auch die Leistungsbegrenzung überwunden werden, die sich aus der Obergrenze für die Einspeisung von Energie in den Trägheitsantrieb ergibt. Die erfindungsgemäße Lösung wird im Patentanspruch 1 angegeben. Verbesserungen und weitere Ausgestaltungen der Erfindung werden in den übrigen Ansprüchen beschrieben.

Der erfindungsgemäße Läufer ist einteilig, das bedeutet die ihn bildenden Masse- und Biegeeinheiten erscheinen im Ergebnis zu einem Körper zusammengefügt. Die einzelnen Masseneinheiten und die einzelnen Biegeeinheiten können jedoch getrennt und unabhängig voneinander hergestellt sein. Bevorzugt ist auch eine Herstellung von vornherein bereits aus einem einzigen Körper.

Mit Hilfe von mindestens einer der flexibel biegbaren Einheiten kann der Andruck des Läufers an die Reibungsoberfläche durch vorspannendes Verbiegen schnell justiert werden. Dadurch kann die Stärke der Haftreibung in einem großen Bereich variiert werden.

Der erfindungsgemäße einteilige Läufer umfaßt mindestens eine flexible verformbare Biegeeinheit und mindestens eine schwere Masseeinheit. Theoretisch könnte die Biegeeinheit auch schwer sein, wenn sie trotzdem relativ zur Masseeinheit flexibel auszubilden wäre, oder theoretisch könnte die Masseeinheit auch flexibel sein, wenn sie trotzdem relativ zur Biegeeinheit schwer wäre. Bei den bekannten festen Stoffen schließen sich jedoch Extremwerte von Masse und Flexibilität gegenseitig aus.

Wie gesagt, ist bei Piezo-Aktuatoren der Einspeisung von Energie in den Trägheitsantrieb eine Obergrenze gesetzt. Auch diesem Problem wird erfindungsgemäß durch die in den Läufer einteilig integrierte Masseeinheit begegnet, so daß trotz der Obergrenze der (sinnvollen) Energieaufnahme ein in der Wirkung leistungsstarker Piezo-Antrieb erhalten wird. Durch die Erfindung wird also der Wirkungsgrad des Piezo-Aktuators - im Prinzip - deutlich verbessert. So kann bei passend gewählter elektrischer Pulsform eine hohe Läufermasse synchron zur Piezobewegung beschleunigt werden, die aufgrund ihrer hohen Trägheit bei schneller Änderung der Piezobewegung auch dann noch in das Gleiten übergeht, wenn die Haftreibung mit Hilfe der flexiblen Biegeeinheit sehr stark eingestellt wurde.

Die hohe Trägheitsmasse und die hoch einstellbare Haftreibung haben gemeinsam mehrere Vorteile zur Folge:
a. Mit dem erfindungsgemäßen Läufer lassen sich auch Objekte höherer Masse transportieren.
b. Die mit dem erfindungsgemäßen Positionierer ausübbaren Kräfte sind bei stark eingestellter Haftreibung sehr hoch.
c. Durch diese Robustheit funktioniert der erfindungsgemäße Positionierer in einem weiten Verbiegungsbereich der flexiblen Biegeeinheit des Läufers, das heißt die Läuferjustage ist extrem fehlertolerant und unempfindlich gegen Änderungen im Betrieb (Verschmutzung, Feuchtigkeit, Korrosion, usw.), welche wie eine Änderung der Haftreibung des Läufers wirken.
d. Für die Bewegung des erfindungsgemäßen Läufers genügt das Anlegen von kleinen Spannungen in der Größenordnung ± 10 Volt an den/die Piezo Aktuator(en), so daß im Gegensatz zu vielen herkömmlichen Trägheitsantrieben keine Hochspannung zum Betrieb notwendig ist, was die Handhabung erheblich erleichtert.
e. Weiterer Vorteil der Erfindung ist die Möglichkeit, durch die Justage des Andrucks über die flexible Biegeeinheit des Läufers an die Reibungsoberfläche die Strecke der Relativbewegung zwischen Läufer und Piezo-Aktuator pro angelegter elektrischer Impulsform einzustellen. Damit kann insbesondere die Strecke der Relativbewegung kleiner gehalten werden als der Stellbereich des Piezo-Aktuators, so daß auch bei großen Verstellbereichen im mm- bis cm-Bereich jede Position mit bis zu atomarer Genauigkeit erreicht werden kann.
f. Durch die Robustheit des erfindungsgemäßen Positionierers bewegt sich der Läufer gleichmäßig und reproduzierbar mit Geschwindigkeiten bis in die Größenordnung Millimeter pro Sekunde.

Die Stärke der Reibung zwischen der Reibungsoberfläche und dem Läufer hängt neben den oben genannten Mechanismen auch von der Größe und Beschaffenheit der Läufer-Kontaktfläche ab. Dieser Parameter ist bei der Fertigung wählbar und bleibt dann eine Konstante, die den Justagebereich für die flexible Biegeeinheit des Läufers festlegt. Erreichbar ist dies, wenn mindestens eine der Masseeinheiten aus einem Körper mit derartig geformter Oberfläche besteht, daß die Größe der an der Reibungsoberfläche anliegenden Fläche durch diese Oberflächenform wählbar ist und/oder daß der oder die Masseeinheiten aus unterschiedlichen Materialien bestehen und Löcher enthalten können.

Die Anforderungen, die an die flexible Biegeeinheit des Läufers gestellt werden, erfüllt ein elastisch dünner Draht, wie er für sich allein in WO-A1-94/06160 vorgeschlagen wird. Ebenso kann eine flexibel biegbare Einheit auch dadurch entstehen, daß eine Masseeinheit an mindestens einer Stelle so weit ausgedünnt wird, daß an dieser Stelle eine Biegbarkeit entsteht, die einer gesonderten flexiblen Biegeeinheit entspricht. Diese Konstruktion hat den Vorteil, daß die Fertigung in einem Stück möglich ist und Nahtstellen zwischen unterschiedlichen Materialien wegfallen können.

Gemäß noch weiterer Erfindung kann an oder in dem Läufer ein Objekt befestigt werden, welches mit dem Läufer mit transportiert wird. Gegebenenfalls kann dieses Objekt mit der gleichen Positioniergenauigkeit wie der Läufer bewegt werden.

Wird nicht der Piezo-Aktuator-Teil statisch im Raum befestigt, sondern nach einem weiteren Erfindungsgedanken der Läufer, indem man diesen an mindestens einem Ende an einem großen, schweren Objekt befestigt, dann führt die Relativbewegung dazu, daß sich in Bezug auf das große Objekt der Piezo-Aktuator bewegt. Dies läßt auch komplexere Konstruktionen zu, die in mehreren Raumrichtungen erfindungsgemäß positionieren können.

Aufgrund der oben beschriebenen großen Kraftreserven des erfindungsgemäßen Läufers können durch Kombination mehrerer dieser Positioniereinheiten und durch Befestigung von Objekten an ihren Läufern komplexe Positionierungen in mehreren Raumrichtungen erfolgen, insbesondere als xy-Tisch, xyz-Stand, Dreibein, Kipptisch oder Rotationselement.

Die Erfindung betrifft eine elektromechanische Positioniereinheit als Trägheitsantrieb zum Positionieren von Objekten mit bis zu atomarer Positionierpräzision und mit Positionierstrecken bis in den cm-Bereich. Die Positioniereinheit enthält mindestens einen rohrförmigen piezoelektrischen Aktuator mit Elektroden zum Anschluß an variable Spannungen zum Erzeugen von elektrisch kontrollierbaren Trägheitsbewegungen auf einen Läufer, welcher sich in diesem(n) Piezo-Aktuator(en) in Richtung der Piezobewegungen entlang einer rohrförmigen Reibungsoberfläche bewegen kann. Die Relativbewegung zwischen Läufer und Piezo-Aktuator entsteht dadurch, daß der Läufer relativ schnellen Bewegungen der Reibungsoberfläche nicht folgt, wohl aber relativ langsamen Bewegungen dieser Reibungsoberfläche. Gegenstand der Erfindung ist ein Läufer, welcher aus mindestens einer Einheit höherer Masse (Masseeinheit) und mindestens einer flexibel verformbaren Einheit (Biegeeinheit) besteht, so daß die Stärke der Reibungshaftung über die flexible Biegeeinheit des Läufers justierbar ist und die Masseeinheit des Läufers für eine hohe Belastbarkeit der Positioniereinheit sorgt. Durch diese Kombination können mit der Positioniereinheit auch schwerere Objekte positioniert werden und für den Einsatz als Werkzeug nötige Kräfte ausgeübt werden.

Anhand der schematischen Darstellung von Ausführungsbeispielen werden weitere Einzelheiten der Erfindung erläutert. Es zeigen:
- Fig. 1: einen Läufer und eine zugehörige Reibungsoberfläche;
- Fig. 2: einen gegenüber Fig. 1 abgewandelten Läufer;
- Fig. 3: einen Läufer mit spezieller Oberfläche;
- Fig. 4 und 5: verschiedene Formen drahtförmiger Biegeeinheiten;
- Fig. 6: eine aus dem Körper einer Masseeinheit herausgearbeitete Biegeeinheit;
- Fig. 7: eine Masseeinheit mit darin befindlichem Objekt;
- Fig. 8: ein Verschiebetisch mit zum Positionieren;
- Fig. 9: ein xy-Tisch als Kombination von Verschiebetischen nach Fig. 8 mit zugehörigem z-Positionierer;
- Fig. 10: eine Kombination von drei flexibel biegbar und orthogonal zueinander zusammenwirkenden Positionierern; und
- Fig. 11: zum Ausführen von Dreh- bzw. Rotationsbewegungen kombinierte Positionierer.

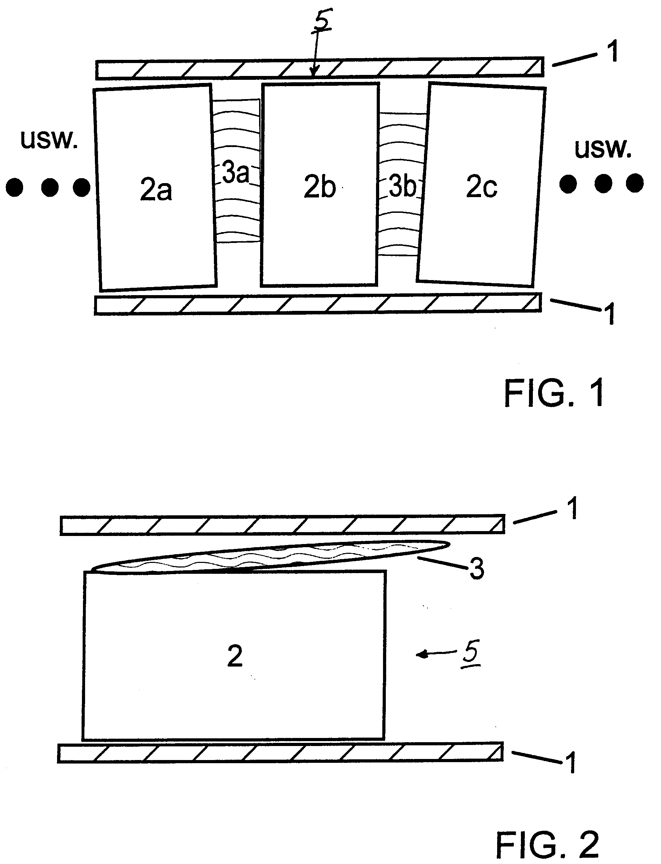

Eine Ausgestaltung des erfindungsgemäßen Läufers zeigt Fig. 1. Die Reibungsoberfläche 1 umfaßt den insgesamt mit 5 bezeichneten Läufer, der in diesem besonderen Fall aus mehreren Masseeinheiten 2a, 2b, 2c, usw. und mehreren flexibel verformbaren Biegeeinheiten 3a, 3b, usw. besteht. Dabei ist die Anzahl der Einheiten nicht entscheidend für das Prinzip, es genügt, wie in Fig. 2 gezeigt, schon je eine Einheit 2, 3. Damit ergibt sich ein großer Gestaltungsfreiraum, der genutzt werden kann, um z.B. in den Läufer 5 Objekte, wie Stromleitungen, Sensoren, Glasfasern oder einen Schlauch, zu integrieren, die dann mit der erfindungsgemäßen Positioniergenauigkeit bewegt werden können.

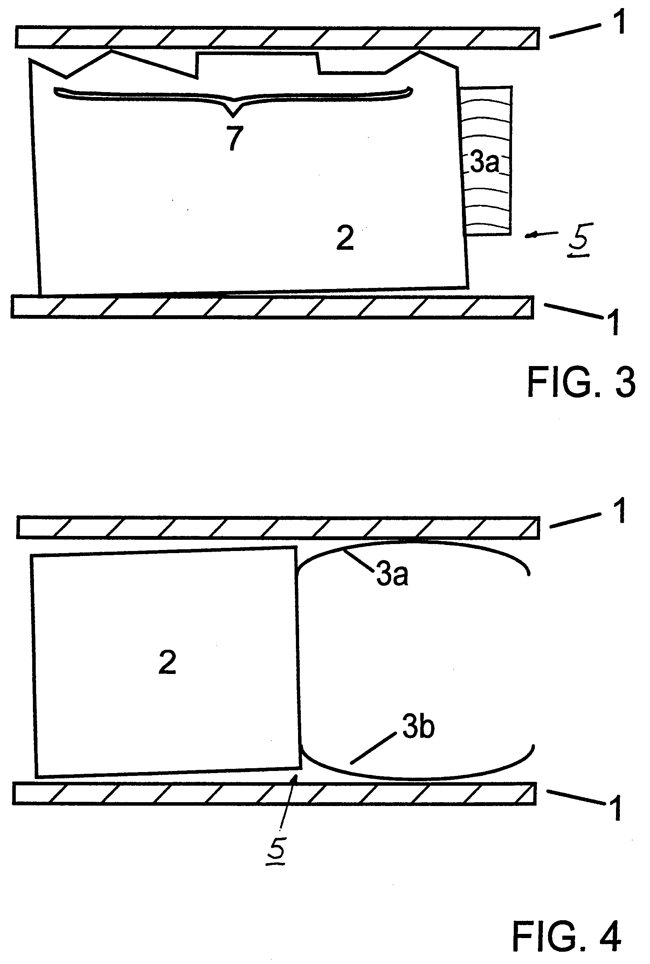

Die Stärke der Reibung zwischen der Reibungsoberfläche 1 und dem Läufer 5 kann unter anderem auch durch die Größe und Beschaffenheit der Läufer-Oberfläche 7 schon bei der Läufer-Fertigung festgelegt werden. Hierzu wird, wie in Fig. 3 gezeigt, mindestens eine der Masseeinheiten 2 an der Oberfläche 7 so geformt, daß die Größe der an der Reibungsoberfläche 1 anliegenden Fläche durch diese Oberflächenform wählbar ist.

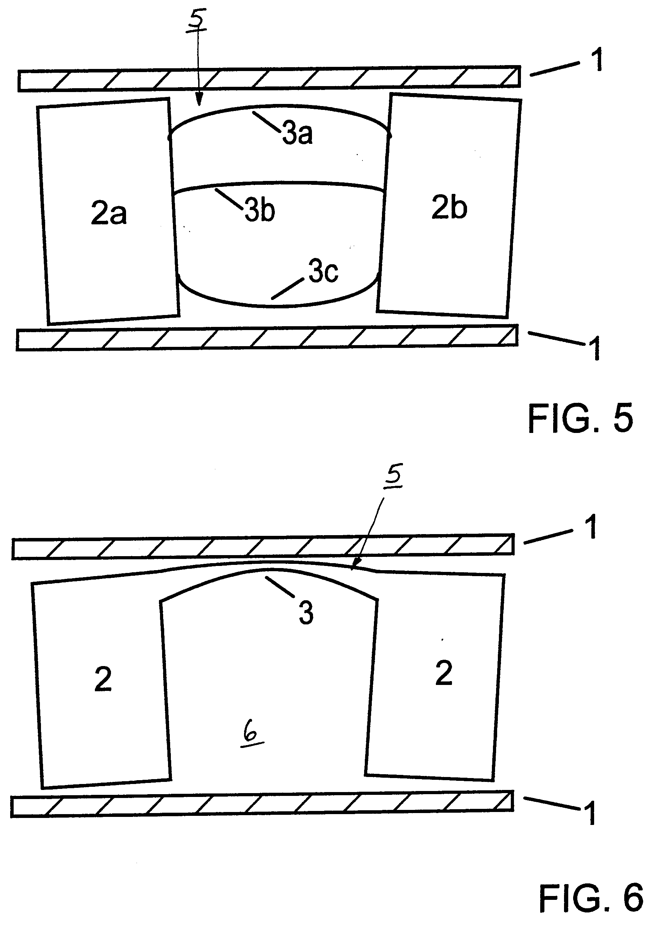

Weitere besondere Ausgestaltungen des erfindungsgemäßen Läufers zeigen Fig. 4 und 5. Dabei bestehen die flexiblen Biegeeinheiten 3a, 3b, usw. aus elastischen dünnen Drähten, die z.B. wie Geißeln (Fig. 4) an einem Ende oder wie Verbindungen zwischen zwei Masseeinheiten (Fig. 5) aussehen können. Auch hier ist die Anzahl der Drähte nicht entscheidend; ein Draht genügt bereits für das erfindungsgemäße Funktionsprinzip. Wie in Fig. 6 gezeigt kann die flexible Biegeeinheit 3 auch dadurch entstehen, daß eine Masseeinheit 2 an mindestens einer Stelle 6 so weit ausgedünnt wird, daß diese Stelle flexibel biegbar wird und die flexible Biegeeinheit darstellt. Auch dieses Prinzip ist mehrfach anwendbar.

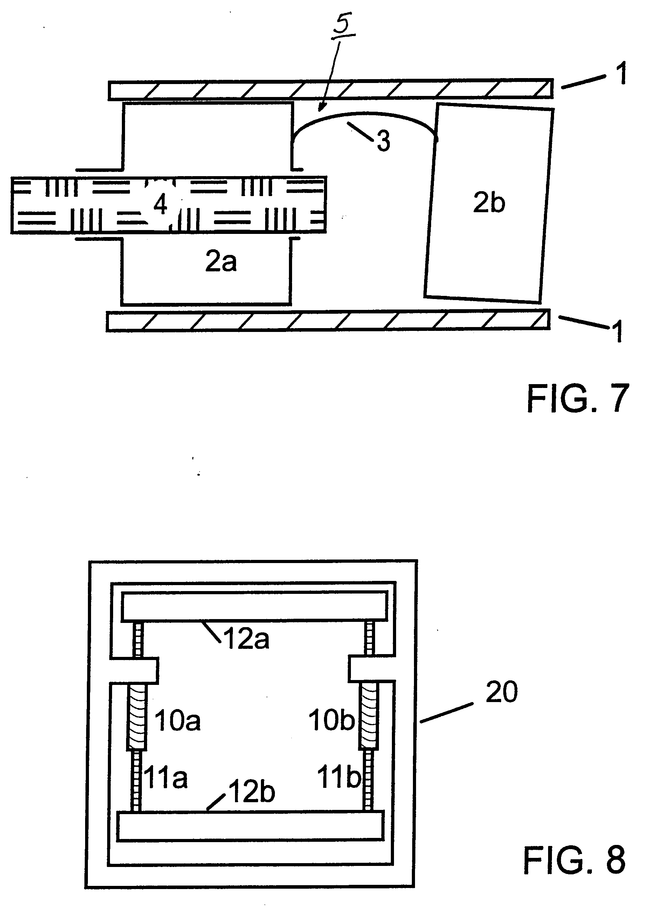

Die Masseeinheit kann in allen vorgestellten Beispielen je nach Verwendungszweck aus verschiedenen Materialien bestehen und/oder axiale Löcher enthalten. So zeigt Fig. 7 ein Beispiel, bei dem in einem der Masseeinheiten 2a ein Objekt 4 befestigt ist. Dies kann ein Stab sein und als Teil eines xy-Positioniertisches dienen, oder ein Spieß, mit dem Material gekratzt werden kann, z.B. zum Durchtrennen von Leiterbahnen, usw.

Die Kombinationen mehrerer der erfindungsgemäßen Positionierer zu komplexeren Geräten zeigen die Fig. 8 bis 10. In Fig. 8 ist eine Ebene des oben erwähnten xy-Tischs dargestellt. Hier liegen zwei der erfindungsgemäßen Positionierer 10a, 10 b parallel in einer Ebene. Ihre Läufer enthalten je einen Stab als zu bewegendes Objekt 11a, 11b. Jeder Stab geht durch seinen Läufer hindurch, bis weit außerhalb des jeweiligen Positionierers 10. Auf den Enden dieser beiden Stäbe sind zwei Platten 12a, 12b befestigt, die bei synchroner Bewegung der beiden Positionierer sich gleichförmig entlang der Bewegungsrichtung der Läufer bewegen. So erhält man erfindungsgemäß einen Verschiebetisch mit Nanometer-Präzision und Bewegungsstrecken im mm- bis cm-Bereich. Dabei können z.B. Lasten größer ca. 100 Gramm mit Geschwindigkeiten bis zu mehr als 1 mm pro Sekunde bewegt werden.

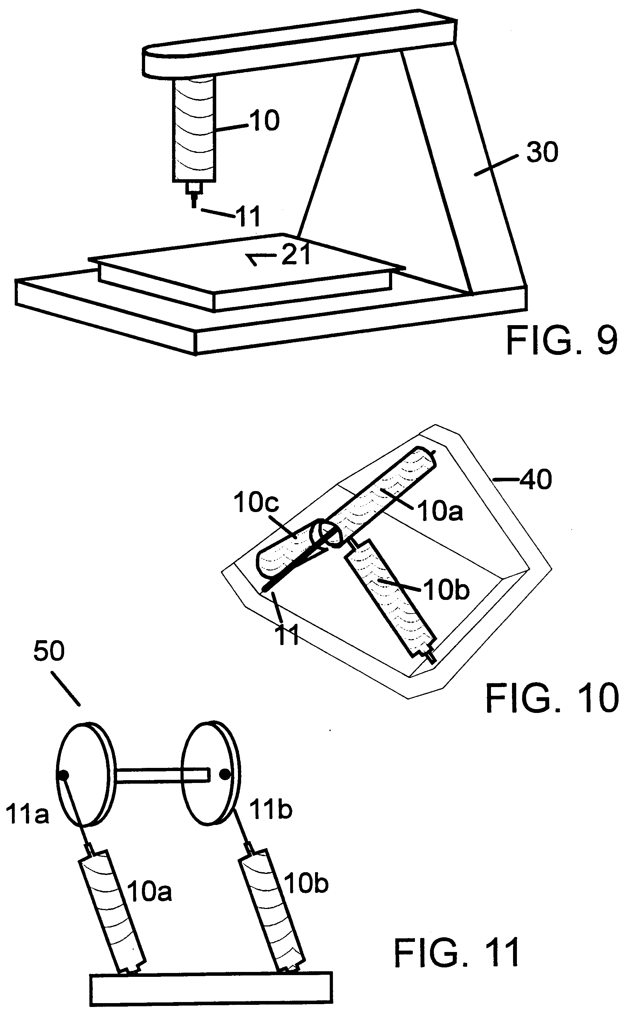

Als Rastersonden-Meßgerät und als Werkzeug einsetzbar ist die in Fig. 9 gezeigte Kombination der erfindungsgemäßen Positionierer. Der xy-Tisch 21 besteht aus zwei um etwa 90 Grad gedreht aufeinanderliegenden Verschiebetischen 20 (nach Fig. 8), also insgesamt aus vier der erfindungsgemäßen Positionierer. Die z-Komponente besteht aus einem fünften erfindungsgemäßen Positionierer 10. Sein Läufer trägt das Objekt 11, bei welchem es sich z.B. um eine Spitze zum Kratzen, Schweißen bzw. Bonden, oder um einen Sensor für elektrischen Strom, Magnetfelder, Licht, Chemikalien, Kräfte usw., oder um einen Schlauch oder eine Glasfaser handeln kann.

Kombiniert man, wie in Fig. 10 gezeigt, drei der erfindungsgemäßen Positionierer 10a, 10b, 10c elastisch über Verbindungen, die nur Biegungen, aber keine Streckung, Stauchung oder Abknickung erlauben, miteinander, so kann ein Objekt 11 dreidimensional im Raum positioniert werden.

Drehbewegungen können durch die Kombination von mindestens zwei der erfindungsgemäßen Positionierer 10a und 10b, wie in Fig. 11 gezeigt, ausgeführt werden. Die beiden einachsigen Bewegungen der Läufer-Arme 11a, 11b werden auf zwei um einen großen Winkel versetzte Stellen einer oder zweier Drehscheiben übertragen. Die Winkelversetzung verhindert Totpunkte, in denen keiner der beiden Positionierer eine Kraft in die Drehbewegung einkoppeln kann. Die mechanische Übersetzung der linearen Bewegung in eine Rotation kann über die bekannte Verwendung des Exzenter-Prinzips erfolgen. Beispiel hierfür ist der Achsenantrieb der Dampflokomotiven.

Keines der oben aufgeführten Anwendungsbeispiele läßt sich mit den herkömmlichen Läufern der einachsigen Trägheitsantriebe, wie in WO-A1-94/06160 und in DE 38 22 504 A1 bzw. in der Zeitschrift Review Sci. Instr. 63 (1) beschrieben, realisieren. Erst die Eigenschaften des erfindungsgemäßen Positionierers sorgen für die hierzu nötige Robustheit.

## Patentansprüche

1. Elektromechanische Positioniereinheit als Trägheitsantrieb zum Positionieren eines flexiblen Läufers (5) mit bis herab zu Nanometer-Positionierpräzision und Positionierstrecken bis herauf in den cm-Bereich, wobei der Läufer (5) mit Friktionskontakt beweglich entlang einer rohrförmigen Reibungsoberfläche (1) in einem rohrförmigen piezoelektrischen Aktuator angeordnet ist und der Aktuator Elektroden zum Anschluß an variable Spannungen besitzt, mit deren Hilfe der Läufer (5) elektrisch kontrollierbar zu bewegen ist,
**dadurch gekennzeichnet**,
daß in den mindestens eine flexibel verformbare Biegeeinheit (3) aufweisenden Läufer (5) mindestens eine gegenüber der Biegeeinheit (3) unflexible und schwere Einheit (2) höherer Masse, Masseeinheit genannt, integriert ist.

2. Positioniereinheit nach Anspruch 1,
**dadurch gekennzeichnet**,
daß die Stärke der den Läufer (5) in Bezug auf die Reibungsoberfläche (1) stabilisierenden Reibungshaftung über mindestens eine flexible Biegeeinheit (3) im Sinne der Funktion eines Trägheitsantriebs justierbar ist.

3. Positioniereinheit nach Anspruch 1 oder 2,
**dadurch gekennzeichnet**,
daß mindestens eine der Masseeinheiten (2) aus einem Körper besteht, dessen Oberfläche so geformt ist, daß die Größe der an der Reibungsoberfläche (1) anliegenden Fläche durch diese Oberflächenform (7) wählbar ist und daß die Masseeinheit aus verschiedenen Materialien bestehen und/oder Löcher enthält.

4. Positioniereinheit nach einem der Ansprüche 1 bis 3,
**dadurch gekennzeichnet**,
daß mindestens eine der flexiblen Biegeeinheiten (3) aus einem elastischen dünnen Draht besteht.

5. Positioniereinheit nach einem der Ansprüche 1 bis 4,
**dadurch gekennzeichnet**,
daß mindestens eine der flexiblen Biegeeinheiten (3) durch entsprechende Ausdünnung mindestens einer der Masseeinheiten gebildet ist.

6. Positioniereinheit nach einem der Ansprüche 1 bis 5,
**dadurch gekennzeichnet**,
daß in oder an wenigstens einem der Läufer (5) mindestens ein Objekt (4) befestigt ist, welches mit dem Läufer mittransportiert wird.

7. Positioniereinheit nach einem der Ansprüche 1 bis 6,
**dadurch gekennzeichnet**,
daß der Läufer (5) an mindestens einem Ende an einem großen, schweren Objekt befestigt ist, so daß die Relativbewegung dazu führt, daß sich in Bezug auf das große Objekt der Piezo-Aktuator bewegt.

8. Positioniereinrichtung, insbesondere als xy-Tisch, xyz-Stand, Dreibein, Kipptisch oder Rotationselement,
**dadurch gekennzeichnet**,
daß mehrere Positioniereinheiten nach mindestens einem der Ansprüche 1 bis 7 kombiniert sind, so daß an den kombinierten Einheiten befestigte Objekte piezoelektrisch an exakt vorbestimmte Raumpositionen, bringbar sind.

## Claims

1. An Electromechanical positioning unit as inertial drive for positioning a flexible slider (5) with down to nanometer positioning precision and with positioning displacements up to the centimeter range, in which the slider (5) is movably arranged with frictional contact along a tube-shaped friction surface (1) in a tube-shaped piezo electric actuator, and the actuator has electrodes for the connection to variable voltages with the help of which the slider (5) can be moved electrically controllable,
**characterized in**
that at least a compared to the bending unit (3) not flexible and heavy unit (2) of higher mass - called mass unit - is integrated into the slider (5), comprising at least a flexible deformable bending unit (3).

2. A positioning unit according to claim 1,
**characterized in**
that the strength of the frictional force stabilizing the slider (5) with respect to the sliding surface (1) is adjustable by at least one flexible unit (3) in the sense of the function of an inertial drive.

3. A positioning unit according to claim 1 or 2,
**characterized in**
that at least one of the mass units (2) consists of a body which surface is formed in a way that the size of the area contacting the sliding surface (1) can be chosen by the form of the surface (7) and that the mass unit consists of different materials and/or has holes.

4. A positioning unit according to one of claims 1 to 3,
**characterized in**
that at least one of the flexible bending units (3) consists of a flexible thin wire.

5. A positioning unit according to one of claims 1 to 4,
**characterized in**
that at least one of the flexible bending units (3) is formed by thinning down of at least one of the mass units.

6. A positioning unit according to one of claims 1 to 5,
**characterized in**
that an object (4) is fixed to or inside at least one of the sliders (5), which is transported with the slider.

7. A positioning unit according to one of claims 1 to 6,
**characterized in**
that the slider (5) is fixed on at least one end to a large, heavy object and that relative motion leads to motion of the piezo actuator with respect to the large object.

8. A positioning device, particularly as xy-table, xyz-stage, tripod, tilting table or rotation element
**characterized in**
that several of the positioning units according to at least one of claims 1 to 7 are combined so that objects fixed to these combined units can be brought piezoelectrically to exactly predetermined positions in space.

## Revendications

1. Unité de positionnement électromécanique comme actionnement d'inertie pour le positionnement d'un curseur (5) flexible avec jusqu'à une précision de positionnement de l'ordre du nanomètre et des segments de positionnement jusqu'à un domaine de l'ordre du cm, à quoi le curseur (5) est placé, avec contact de friction, mobilement le long d'une surface de frottement (1) tubulaire dans un actuateur piézo-électrique tubulaire, et l'actuateur possède des électrodes pour le branchement à des tensions variables, avec lesquelles le curseur (5) peut être contrôlé dans son mouvement électriquement,
**caractérisée en ce que**
dans le curseur (5) présentant au moins une unité de courbure (3) flexiblement déformable, est intégrée au moins une unité (2) non flexible et lourde par rapport à l'unité de courbure (3) de masse plus grande, dénommée "unité de masse".

2. Unité de positionnement suivant revendication 1,
**caractérisée en ce que**
l'intensité de l'adhérence par frottement, stabilisant le curseur (5) par rapport à la surface de frottement (1) est ajustable par au moins une unité de courbure (3) flexible dans le sens de la fonction d'un actionnement d'inertie.

3. Unité de positionnement suivant revendication 1 ou 2,
**caractérisée en ce que**
au moins une des unités de masse (2) est constituée d'un corps dont la surface est formée de telle sorte, que la taille de la surface collant à la surface de frottement (1) peut être choisie par cette forme de surface (7), et que l'unité de la masse est constituée de plusieurs matériaux et/ou comporte des trous.

4. Unité de positionnement suivant une des revendications de 1 à 3,
**caractérisée en ce que**
au moins une des unités de courbure (3) flexibles est constituée d'un fil métallique fin élastique.

5. Unité de positionnement suivant une des revendications de 1 à 4,
**caractérisée en ce que**
au moins une des unités de courbure (3) flexibles est formée par un amincissement correspondant au moins d'une des unités de masse.

6. Unité de positionnement suivant une des revendications de 1 à 5,
**caractérisée en ce que**
dans ou à au minimum un des curseurs (5) est fixé au moins un objet (4), lequel est transporté avec le curseur.

7. Unité de positionnement suivant une des revendications de 1 à 6,
**caractérisée en ce que**
le curseur (5) est fixé à au moins une extrémité à un objet grand et lourd, de sorte que le mouvement relatif amène le piézo-actuateur à se déplacer par rapport au grand objet.

8. Le dispositif de positionnement, en particulier comme table xy, stand xyz, trépied, table culbutante ou élément de rotation
**caractérisé en ce que**
plusieurs unités de positionnement sont combinées selon au moins une des revendications de 1 à 7, de sorte que des objets fixés à des unités combinées sont amenés piézoelectroniquement à des positions dans l'espace exactement prédéterminées.
